Europäisches Patentamt

European Patent Office

Office européen des brevets

(11) Numéro de publication : **0 286 464 B1**

# (12) FASCICULE DE BREVET EUROPEEN

(45) Date de publication du fascicule du brevet :
**06.05.92 Bulletin 92/19**

(51) Int. Cl.$^5$ : **H03G 11/02, H01P 1/185, H01P 1/15**

(21) Numéro de dépôt : **88400516.6**

(22) Date de dépôt : **04.03.88**

(54) **Dispositif hyperfréquence à diodes comportant une ligne triplaque.**

(30) Priorité : **06.03.87 FR 8703075**

(43) Date de publication de la demande :
**12.10.88 Bulletin 88/41**

(45) Mention de la délivrance du brevet :
**06.05.92 Bulletin 92/19**

(84) Etats contractants désignés :
**DE GB NL**

(56) Documents cités :
**FR-A- 973 664
FR-A- 2 071 043
FR-A- 2 133 169
US-A- 3 309 626
IEEE TRANSACTIONS ON MICROWAVE
THEORY AND TECHNIQUES, vol. MTT-22, no.
6, juin 1974, pages 675-687; R.W. BURNS et al.:
"Lowcost design techniques for semiconductor phase shifters"
ELECTRONICS LETTERS, vol. 17, no. 19, 17th
September 1981, pages 702,703, Londres, GB;
G.N.O. UGWUAGU et al.: "Pin diodes inmean-
der-line filters for multiplexing applications"**

(56) Documents cités :
**PHILIPS TECHNISCH TIJDSCHRIFT, vol. 32,
no. 6/7/8/9, 1971, pages 277-284; J.H.C. VAN
HEUVEN: "Pin-schakeldiodes infasedraaiers
voor elektronisch bestuurde antennesystemen"
PATENT ABSTRACTS OF JAPAN, vol. 4, no.
137 (E-27)[619], 25 septembre 1980; & JP-A-55
90 101 (TOKYO SHIBAURA DENKI K.K.)08-
07-1980
H.J. REICH et al.: "Microwave theory and
techniques, 1953, pages 131-141, D. Van Nostrand Co., Inc., New York, US**

(73) Titulaire : **THOMSON COMPOSANTS
MICROONDES
173, bld Haussmann
F-75008 Paris (FR)**

(72) Inventeur : **Vedrenne, Christian
THOMSON-CSF SCPI 19, avenue de Messine
F-75008 Paris (FR)**
Inventeur : **Desmarest, Patrick
THOMSON-CSF SCPI 19, avenue de Messine
F-75008 Paris (FR)**
Inventeur : **Guerin, Bernard
THOMSON-CSF SCPI 19, avenue de Messine
F-75008 Paris (FR)**

(74) Mandataire : **Taboureau, James et al
THOMSON-CSF SCPI
F-92045 Paris La Défense Cédex 67 (FR)**

EP 0 286 464 B1

Il est rappelé que : Dans un délai de neuf mois à compter de la date de publication de la mention de la
délivrance du brevet européen toute personne peut faire opposition au brevet européen délivré, auprès
de l'Office européen des brevets. L'opposition doit être formée par écrit et motivée. Elle n'est réputée
formée qu'après paiement de la taxe d'opposition (Art. 99(1) Convention sur le brevet européen).

## Description

La présente invention concerne un dispositif hyperfréquence comportant une ligne triplaque et au moins un limiteur passif constitué par deux diodes électriquement en série, la ligne suspendue entre les deux plans de masse de la ligne triplaque constituant un point commun aux diodes.

L'objet de l'invention a été mis au point pour que les diodes soient facilement accessibles lorsque le dispositif est monté dans un matériel hyperfréquence complexe, et à cette fin les diodes sont montées d'un même côté de la ligne suspendue.

Afin que l'exposé de l'invention soit clair et homogène, l'exemple d'un limiteur de puissance sera choisi pour soutenir le texte et les figures, sans que ceci ne limite la portée de l'invention qui concerne tout dispositif dans lequel deux diodes en série sont montées de part et d'autre d'une ligne triplaque, d'un point de vue électrique. En effet, selon la configuration choisie, le dispositif objet de l'invention est un limiteur de puissance, ou un déphaseur de puissance, ou, si les diodes sont polarisées, un commutateur.

On appelle ligne triplaque un élément de propagation d'une onde hyperfréquence, dans lequel une ligne métallique est suspendue dans un milieu diélectrique, qui peut être de l'air ou un diélectrique solide, entre deux plans de masse situés de part et d'autre de la ligne suspendue métallique. Une ligne triplaque agit, dans le domaine des circuits hyperfréquence, d'une façon comparable aux lignes coaxiales.

Il est connu que deux diodes en série, montées entre un premier plan de masse, la ligne suspendue comme point commun aux deux diodes, et un second plan de masse, fonctionnent en limiteur et donnent toute satisfaction du point de vue électrique. Cependant, si on considère un tel limiteur monté dans un matériel complexe, il apparait qu'il n'est pas commode, pour le montage, le règlage et l'entretien du limiteur, d'avoir des diodes qui sont situées des deux côtés de la ligne suspendue. S'il faut intervenir sur une ou plusieurs diodes par exemple, cela nécessite de démonter toute la ligne triplaque, qui est souvent mal placée de ce point de vue mécanique, contre un guide d'onde ou un circulateur, et qui n'est pas facilement accessible.

L'invention apporte donc une solution aux problèmes de l'accessibilité et à la maintenance d'un limiteur de puissance.

Selon l'invention, les deux diodes d'un ensemble limiteur passif à diodes sont ramenées sur une même face de la ligne suspendue au moyen de deux tronçons de ligne annexe qui sont dans le même plan que la ligne principale, et lui sont sensiblement orthogonaux. Ces tronçons ont une longueur égale ou multiple de $\lambda_g/2$, $\lambda_g$ étant la longueur d'onde guidée dans la ligne. Le trajet aller-retour d'une onde dans chaque ligne annexe est égal ou multiple de $\lambda_g$ : l'action d'une diode montée en bout de ligne annexe est donc la même que si cette diode était montée dans l'axe de la ligne principale. Il est alors possible de monter les deux diodes aux deux extrémités des deux tronçons de lignes annexes, mais du même côté par rapport à la ligne principale, en tête-bêche.

De façon plus précise, l'invention concerne un dispositif hyperfréquence à diodes, comportant une ligne triplaque formée par une ligne suspendue placée entre deux plans de masse, et au moins deux diodes, montées en série et exerçant leur action en un même point central de la ligne suspendue, qui transporte un signal hyperfréquence de longueur d'onde guidée $\lambda_g$, ce dispositif étant caractérisé en ce que deux tronçons de lignes annexes sont raccordés à la ligne suspendue principale, et lui sont orthogonaux, et en ce que les deux diodes sont montées dans un même plan mécanique et d'un même côté par rapport à ce plan formé par la ligne suspendue principale et par les deux lignes annexes, chacune des deux diodes à une extrêmité libre d'un tronçon de ligne annexe, en un point distant de $\lambda_g/2$ ou d'un multiple de $\lambda_g/2$ du point central de la ligne suspendue principale, situé dans le même plan mécanique, l'effet des deux diodes en hyperfréquence étant ramené au dit point central de la ligne suspendue.

L'invention sera mieux comprise par la description détaillée qui suit d'un exemple de réalisation de limiteur de puissance, cette description s'appuyant sur les figures jointes en annexe qui représentent :

– figure 1 : schéma synoptique d'un limiteur passif à diodes, selon l'art connu,

– figure 2 : schéma électrique d'un élément de limitation, dont le fonctionnement est mis en oeuvre dans le limiteur de la figure 1,

– figures 3 et 4 : réalisation pratique de limiteur de la figure 2, selon l'art connu,

– figure 5 : élément de ligne suspendue selon l'invention,

– figures 6 et 7 : variante de la figure 5, pour supporter une plus grande puissance, selon l'invention,

– figure 8 : dessin de réalisation de ligne suspendue d'un limiteur de puissance selon l'invention,

– figure 9 : vue en coupe d'une ligne triplaque réalisée selon l'invention.

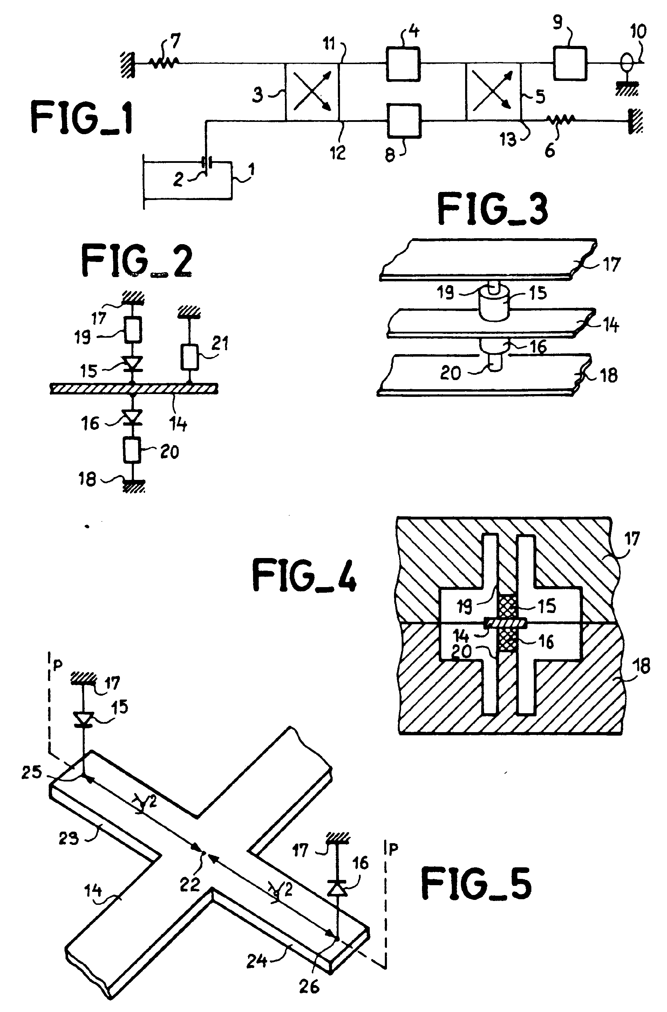

Les figures 1 à 4 permettront de mieux comprendre le problème résolu par l'invention, qui apporte une solution électrique à un problème mécanique.

Il est parfois nécessaire de limiter l'amplitude de signaux hyperfréquence, et dans ce cas, selon une solution reconnue pour son efficacité, la fonction limitation est assurée principalement par des diodes PIN, montées tête-bêche dans une structure triplaque.

L'avantage de ce type de procédé est d'être entièrement passif, la limitation passive, sans commande extérieure, étant plus fiable qu'une limitation active et, en tout cas, indispensable lorsqu'on recherche une protection contre les signaux aléatoires.

La figure 1 représente le schéma synoptique d'un limiteur passif à diodes, tel que celui sur lequel porte l'invention.

L'énergie hyperfréquence qui circule dans un guide d'onde 1 est prélevée par une sonde 2 et adressée à un limiteur, par l'intermédiaire d'un coupleur dit 3 db, symbolisé en 3 sur la figure. Une première branche du limiteur comporte à partir d'une sortie 11 du coupleur 3 db un dispositif de limitation à diodes 4, puis une diagonale d'un second coupleur 3 db repéré en 5 et l'énergie est absorbée à travers une charge 6 reliée à la masse. Une seconde branche du limiteur comprend à partir d'une charge absorbante 7 dont une extrêmité est reliée à la masse, une diagonale du premier coupleur 3 db avec sortie par sa borne 12, puis un dispositif de limitation à diodes repéré en 8, une diagonale du second coupleur 3 db repéré en 5, un second étage de limitation repéré 9 et sortie par un coaxial en 10.

En fonctionnement, une partie du signal hyperfréquence prélevé par la sonde 2 est réfléchi par les dispositifs de limitation 4 et 8. Le dispositif de limitation 9, limite l'amplitude du signal hyperfréquence issu des dispositifs de limitation 4 et 8, sur la sortie coaxiale 10. Le signal réfléchi par 9 est absorbé par la charge 6.

Les dispositifs de limitation symbolisés par des blocs 4 - 8 et 9 sont chacun constitués par au moins un dispositif à deux diodes, tels que représentés en figure 2, et décrits dans le brevet FR-A- 2 133 169 déposé le 9 Avril 1971 par la demanderesse et publié le 24/11/1972.

Selon ce brevet, l'énergie hyperfréquence circulant dans une ligne suspendue 14 est limitée par deux diodes 15 et 16 montées en série, la ligne suspendue 14 étant connectée au point commun entre ces deux diodes. L'une des diodes 15 est réunie à un premier plan de masse 17 de la ligne triplaque, et l'autre diode 16 est réunie à l'autre plan de masse 18 de cette même ligne triplaque. Les diodes 15 et 16 sont préférentiellement des diodes PIN.

Une diode PIN comprend deux zones fortement dopées $P^+$ et $N^+$ de part et d'autre d'une zone I de haute résistivité, et se comporte à bas niveau comme une capacité à résistance de fuite élevée, et à fort niveau comme une résistance faible, la zone I étant inondée de porteur injecté.

La limitation passive par diodes s'obtient en positionnant dans un même plan hyperfréquence, c'est-à-dire dans un même plan orthogonal à la ligne suspendue 14, des diodes associées par paires, telles que les diodes 15 et 16. Placées en shunt dans une ligne de transmission et grace en général à un accord série représenté par les dispositifs 19 et 20, et à un accord parallèle complémentaire représenté par le dispositif 21, elles rendent minimales les pertes à bas niveau et maximale la limitation à fort niveau.

Le montage de deux diodes en série est particulièrement intéressant parce qu'il réalise le retour du courant continu détecté mais surtout parce qu'il permet de réduire considérablement le régime transitoire très dissipatif au début de chaque impulsion incidente à forte puissance crête, la résistance à fort niveau n'étant pas encore très faible car il y a peu de porteurs injectés.

La réalisation pratique d'un limiteur selon ce principe se fait conformément à la figure 3 qui est simplifiée et à la figure 4 qui est une coupe de la ligne triplaque pourvue d'un limiteur. Les diodes 15 et 16 sont montées à l'intérieur de boîtiers cylindriques, directement soudés sur la ligne suspendue 14, et les moyens d'adaptation en série 19 et 20 se présentent sous la forme d'une longueur de coaxial.

Selon la coupe de la figure 4, on voit que ces longueurs de coaxial 19 et 20 sont usinées dans la masse de métal des plans de masse 17 et 18.

D'un point de vue mécanique, une ligne triplaque est un élément relativement volumineux et lourd, essentiellement composé de deux blocs métalliques 17 et 18 qui sont attachés l'un à l'autre par un grand nombre de boulons qui les traversent, étant entendu qu'une ligne dans laquelle se propage une énergie hyperfréquence ne doit pas présenter de fuites qui abaissent le rendement et sont dangereuses pour l'environnement.

Lorsqu'il faut adapter ou remplacer par exemple une diode telle que 15 ou 16, on conçoit facilement que le démontage de la ligne triplaque est une opération délicate si celle-ci entourée par d'autres dispositifs qui coopèrent avec elle dans la réalisation du matériel hyperfréquence.

C'est donc un premier objet de l'invention que de trouver une solution électrique à ce problème de mécanique, et que les diodes soient montées d'un même côté, de préférence vers l'extérieur du matériel hyperfréquence, par rapport à la ligne suspendue 14.

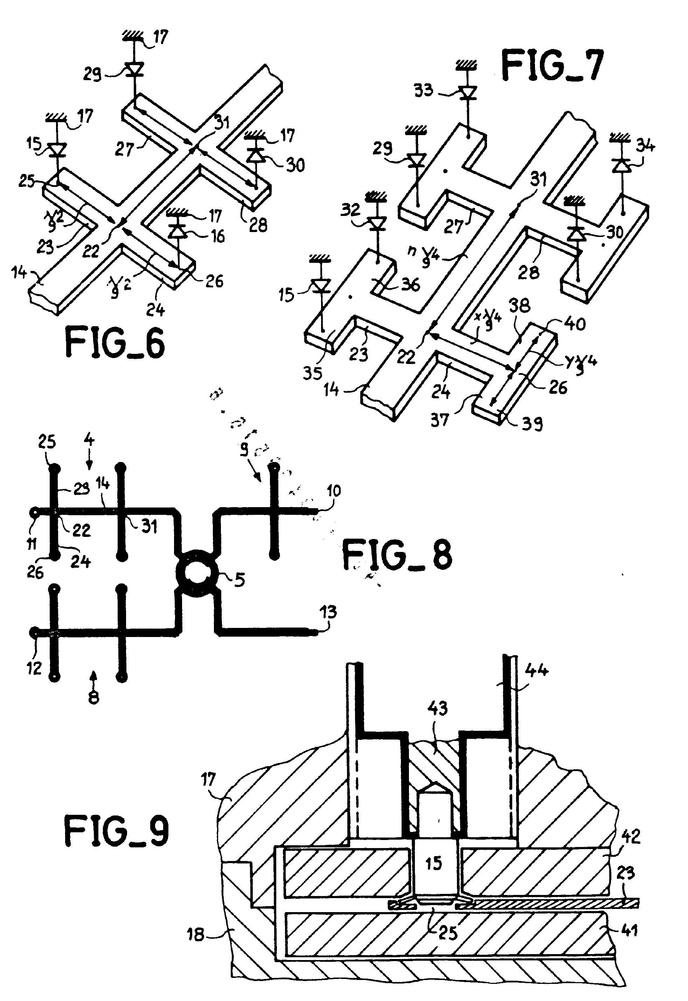

C'est ce que représente la figure 5, dans laquelle seulement un élément de la ligne suspendue 14 est dessiné, de façon à simplifier la figure, en vue de donner l'explication du fonctionnement d'un limiteur à diode selon l'invention.

Soit un élément de ligne suspendue 14, baignant dans un milieu diélectrique entre deux plans de masse 17 et 18 quine sont pas représentés sur cette figure.

Soit 22 un point de cette ligne suspendue 14, dans le plan duquel sont normalement, selon l'art antérieur, raccordées deux diodes l'une en-dessus l'autre en-dessous de la ligne suspendue 14.

On appelle plan mécanique, un plan symbolisé par la trace P, passant par le point 22 : ce plan est orthogonal à la ligne suspendue 14.

Selon l'invention, deux tronçons de lignes suspendues 23 et 24 sont ajoutés à la ligne suspendue 14, ces tronçons passant par le point 22 situé dans le plan mécanique P. Les tronçons de lignes annexes 23 et 24 ont une longueur légèrement supérieure à $\lambda_g/2$, $\lambda_g$ étant la longueur d'onde guidée dans la ligne.

En deux points repérés 25 et 26 et situés à une distance ou à un multiple de $\lambda_g/2$ par rapport au point d'origine 22, sont fixées deux diodes 15 et 16, d'un même côté par rapport à la ligne suspendue 14. Ces diodes 15 et 16 sont montées tête-bêche, c'est-à-dire que l'anode de l'une est reliée à un tronçon de ligne annexe 24 et sa cathode est reliée au plan de masse 17, tandis que la cathode de l'autre est reliée au tronçon de ligne annexe 23 et son anode est reliée au plan de masse 17.

D'un point de vue électrique, le trajet parcouru par l'onde hyperfréquence au point 22 est égal à $\lambda_g/2$ pour l'aller et $\lambda_g/2$ pour le retour soit une distance $\lambda_g$ : par conséquent, une diode agissant au point 25 ou au point 26 a la même action que si elle était reliée électriquement au point 22. Ce montage de deux lignes annexes, perpendiculaires à la ligne principale, ayant une longueur au moins égale à $\lambda_g/2$ permet de monter les deux diodes d'un limiteur sur une même face de la ligne suspendue 14.

Le montage représenté en figure 6 permet d'avoir deux étages de limitation en série sur une même ligne suspendue 14. Le premier étage de limitation est constitué, comme celui de la figure 5, par deux diodes 15 et 16 montées tête-bêche à l'extrêmité de deux tronçons de lignes anexes 23 et 24. Le second étage de limitation est identique au précédent, et il comporte deux diodes 29 et 30 montées aux extrémités de deux troçons de lignes annexes 27 et 28. Les mêmes règles de conception jouent pour le second étage de limitation. La distance qui sépare le premier étage du second étage de limitation, c'est-à-dire la distance entre les points 22 et 31 dans deux plans parallèles, est un multiple de $\lambda_g/4$.

Le montage représenté en figure 7 permet de supporter davantage de puissance, pour un même étage de limitation. Ce montage correspond à un limiteur à deux étages, comme celui de la figure 6, mais la puissance qui peut être absorbée pour chaque étage est double.

En effet, le limiteur du premier étage, placé dans un plan hyperfréquence passant par le point 22, comporte deux tronçons de lignes annexes 23 et 24, qui sont eux-mêmes dédoublés dans leur partie extérieure par rapport à la ligne suspendue principale 14. Le tronçon de ligne annexe 23 a une longueur qui est un multiple de $\lambda_g/4$, par exemple x $\lambda_g/4$, et il a une forme en T, les deux branches 35 et 36 de ce T reliées à la branche 23, ayant elles-mêmes une longueur multiple de $\lambda_g/4$ par exemple y$\lambda_g/4$. Il en est de même pour le second tronçon de ligne annexe 24, qui est prolongé par deux tronçons 37 et 38 formant un T. La distance aller-retour d'une onde hyperfréquence présente au point 22 sur la ligne suspendue 14, jusqu'aux points 39 et 40, situés aux extrêmités des lignes annexes en T, doit-être telle quelle soit égale ou un multiple de $\lambda_g/2$ :

$$x\lambda_g/4 + y\lambda_g/4 = z\lambda_g/2.$$

Ainsi des diodes fixées aux points 39 et 40 ont donc le même effet que si elles étaient fixées au point 22.

Toutes les diodes n'ont pas été représentées sur cette figure 7, de façon à alléger le dessin, mais il est évident qu'elles sont montées conformément à ce qui a été exposé jusqu'à présent, et que les deux diodes fixées sur une même ligne annexe en T, telle que 24, sont montées dans le même sens.

La figure 8 donne le dessin de réalisation de la ligne suspendue dans un limiteur de puissance selon l'invention, réalisée en ligne triplaque conformément au dessin de la figure 1. Cette ligne suspendue a 4 extrêmités qui correspondent respectivement à:
– les entrées 11 et 12 sont les sorties du coupleur 3 db repéré 3 en figure 1,
– la sortie 13 correspond à la sortie du coupleur 3 db repéré 5 et réunie à une charge mise à la masse,
– la sortie 10 est réunie à un connecteur coaxial.

Cette ligne suspendue comprend deux étages de limitation montés en parallèle dans deux voies, et un étage supplémentaire de limitation en 9, sur la voie de sortie réunie au connecteur coaxial 10.

Par comparaison avec la figure 6, on reconnait que deux diodes sont montées dans un même plan mécanique défini soit par le point 22 soit par le point 31, et que ces diodes sont réunies électriquement à l'extrêmité 25 ou 26 des tronçons de lignes annexes 23 et 24.

Le limiteur pour lequel l'invention a été faite est un limiteur de puissance, et l'utilisation d'un coupleur 3 db à l'entrée permet de diminuer de moitié la puissance reçue par chaque étage de diode. Le premier étage de diodes 15 et 16 placé dans une voie ne verra en cas d'avarie de fonctionnement qu'une puissance moitié, pendant un temps de l'ordre de 5 micro-secondes. Pour assurer une bonne limitation, des diodes PIN au silicium sont utilisées. Elles ont comme principale caractéristique en technologie mésa passivée:
– une tension de claquage de l'ordre de 50 volts pour améliorer la limitation,
– une capacité de jonction de l'ordre de 0,5 pF.

Ces diodes sont des diodes simples, ou bien des diodes montées en série dans un même boîtier. Ceci permet de doubler la surface de la puce de diode tout en conservant en régime de fonctionnement une capacité de jonction identique. Un tel montage permet d'améliorer la caractéristique thermique de la diode et donc sa durée de vie. Les performances du premier étage de puissance de ce limiteur sont de 20 db de limitation et 0,3 db de perte.

Le deuxième étage du limiteur, dans chacune des branches, est toujours constitué de diodes montées dans un même plan mécanique passant par le point 31. Ce point 31 est situé dans un plan distant de λ/4 ou d'un multiple du plan passant par le point 22 du premier étage, et les diodes sont de ce fait adaptées.

Ce second étage de diodes peut être réalisé avec des diodes PIN au silicium identiques aux diodes du premier étage, mais il peut également être réalisé avec des diodes varactor à arséniure de gallium. Quelque soit la solution retenue cet étage a une limitation de 20 db, plus 6 db dus à la présence de l'étage de limitation précédent, et des pertes égales à 0,3 db si les diodes sont en silicium et à 0,2 db si les diodes sont en arséniure de gallium.

Les deux branches de limitation sont couplées dans un coupleur 3 db représenté en 5, et après la sortie du coupleur un étage supplémentaire de limitation est monté sur la voie de sortie qui va vers le connecteur au point 10. Le rôle de cet étage supplémentaire de limitation est de limiter la puissance émergente à un niveau tel que 10 milliwatts en régime de fonctionnement normal et 40 milliwatts en cas d'avarie. Les diodes utilisées sont des diodes de type arséniure de gallium ou silicium, fonctionnant en ecrêteur et évitant ainsi tout phénomène de parasite sur le signal de sortie. Les performances de l'étage final de limitation sont de 20 db en limitation et 0,2 db de perte.

Cette ligne suspendue 14, découpée dans une feuille de métal suffisamment épaisse pour pouvoir être manipulée, est montée conformément à la figure 9 pour constituer un limiteur en ligne triplaque.

Sur la figure 9, qui représente en coupe l'extrêmité d'une ligne annexe telle que 23, 24, le tronçon 23 de la ligne suspendue est maintenu entre deux plaques de diélectrique, alumine ou téflon par exemple, repérées en 41 et 42. Ces deux plaques sont elles-mêmes serrées entre deux blocs conducteurs métalliques formant plan de masse 17 et 18. Dans l'une des plaques de diélectrique, 42 par exemple, et à une position correspondant à l'extrêmité 25 d'une ligne annexe 23, un trou permet de positionner une diode 15 montée dans un boîtier cylindrique, et muni d'une tige 43 qui sert à la fois à la maintenir, à l'appliquer contre la ligne annexe 23, et à former un moyen adaptation en série tel qu'une ligne coaxiale. Une vis métallique 44, passant dans un orifice fileté pratiqué dans le plan de masse 17 établit le contact avec la diode 15, par l'intermédiaire de sa queue 43 formant ligne coaxiale.

Bien entendu, la figure 9 ne représente qu'une petite partie de la coupe complète d'un limiteur en ligne triplaque, mais il en ressort que toutes les diodes étant montées d'un même côté par rapport à la ligne suspendue centrale, il suffit de dévisser les vis 44 pour avoir accès aux diodes 15 - 16 - 29 - 30 etc ..., et pouvoir changer de type de diode, ou les accorder par la longueur de coaxial 43.

L'accessibilité et la maintenance d'un limiteur selon l'invention sont donc bien supérieures à ce qui se faisait avec les limiteurs selon l'art connu.

L'invention est exposée en s'appuyant sur le cas d'un limiteur; toutefois, si l'on fait varier la longueur des lignes annexes telles que 23 et 24, ou la distance entre deux plans mécanique passant par les points 22 et 31, on peut en faire un déphaseur. En outre, les diodes sont dans un limiteur reliées au plan de masse 17, étant entendu que les plans de masse 17 et 18 sont en contact électrique. Si au lieu de relier les diodes à la masse on les polarise, on peut faire un commutateur.

De façon plus générale, l'invention s'applique à tous dispositifs hyperfréquence utilisant deux diodes montées par rapport à l'ame centrale d'une ligne triplaque, et elle concerne les matériels hyperfréquence utilisés pour les radars et les télécommunications ou les satellites. Elle est précisée par les revendications suivantes.

**Revendications**

1. Dispositif hyperfréquence à diodes, comportant une ligne triplaque formée par une ligne suspendue (14) placée entre deux plans de masse (17, 18), et au moins deux diodes (15, 16) montées en série et exerçant leur action en un même point central (22) de la ligne suspendue (14), qui transporte un signal hyperfréquence de longueur d'onde guidée λg, ce dispositif étant caractérisé en ce que deux tronçons de lignes annexes (23,24) sont raccordés à la ligne suspendue principale (14), et lui sont orthogonaux, et en ce que les deux diodes (15,16) sont montées, dans un même plan mécanique (P) et d'un même côté par rapport à ce plan formé par la ligne suspendue principale (14) et par les deux lignes annexes (23, 24), chacune des deux diodes à une extrêmité libre d'un tronçon de ligne annexe (23,24), en un point (25,26) distant de λg/2 ou d'un multiple de λg/ 2 du point central (22) de la ligne suspendue principale (14), situé dans le même plan mécanique (P), l'effet des deux diodes étant ramené au dit point central (22) de la ligne suspendue (14).

2. Dispositif hyperfréquence selon la revendication 1, caractérisé en ce que les deux diodes (15,16) sont montées, l'une (16) avec l'anode réunie à une ligne annexe (24) et la cathode à la masse (17), l'autre (16) avec la cathode réunie à l'autre ligne annexe (23) et l'anode à la masse (17).

3. Dispositif hyperfréquence selon la revendication 1, caractérisé en ce que, en vue d'augmenter son effet, il comporte au moins un second étage (27, 28, 29, 30) identique au premier (15, 16, 23, 24) et composé de deux tronçons de lignes annexes (27, 28) raccordés à la ligne suspendue principale (14), et lui étant orthogonaux, et de deux diodes (29, 30) connectées aux lignes annexes (27,28) en deux points distants de λg/2 ou d'un multiple de λg/2 d'un point central (31) de la ligne principale (14), la distance, mesurée le long de la ligne principale (14), entre le premier étage (23,24) et le second étage (27, 28) étant un multiple de λg/4.

4. Dispositif hyperfréquence selon la revendication 1, caractérisé en ce que, en vue d'augmenter sa puissance, les deux tronçons de lignes annexés (23,24) sont chacun en forme de T, quatre diodes étant connectées aux quatre extrémités des lignes annexes (23, 24) dont les bras (35, 36) (37, 38) ont une longueur au moins égale ou multiple de λg/4, de sorte que les diodes sont connectées à une distance du point central (22) de la ligne principale (14) égale ou multiple de λg/2.

5. Dispositif hyperfréquence selon la revendication 4, caractérisé en ce que, pour chaque ligne annexe, les diodes (15,32) sont connectées en parallèle, dans le même sens, aux extrêmités des bras (35,36) du T.

6. Dispositif hyperfréquence selon l'une quelconque des revendications 1 à 5, caractérisé en ce que, les diodes étant connectées à la masse, ce dispositif est un limiteur hyperfréquence.

7. Dispositif hyperfréquence selon l'une quelconque des revendications 1 à 5, caractérisé en ce que, les diodes étant connectées à la masse, et les longueurs des lignes annexes (23,24,27,28) et les distances entre les étages du dispositif étant variables, ce dispositif est un déphaseur hyperfréquence.

8. Dispositif hyperfréquence selon l'une quelconque des revendications 1 à 5, caractérisé en ce que, les diodes étant polarisées par une tension, ce dispositif est un commutateur hyperfréquence.

9. Dispositif hyperfréquence selon l'une quelconque des revendications 1 à 8, caractérisé en ce que, les diodes étant situées d'un même côté par rapport au plan formé par la ligne principale (14) et les lignes annexes (23, 24, 27, 28) chaque diode (15, 16, 29, 30) est maintenue contre une ligne annexe (23, 24) au moyen d'une vis qui traverse le plan de masse (17).

## Patentansprüche

1. Ultrahochfrequenzeinrichtung mit Dioden, die eine Dreiplattenleitung umfaßt, die aus einer zwischen zwei Masseebenen (17, 18) angeordneten hängenden Leitung (14) und aus wenigstens zwei Dioden (15, 16), die in Reihe geschaltet sind und ihre Wirkung auf denselben mittigen Punkt (22) der hängenden Leitung (14) ausüben, gebildet ist, wobei die hängende Leitung (14) ein Ultrahochfrequenzsignal mit einer Wellenlänge λg der leitungsgebundenen Welle transportiert, wobei die Einrichtung dadurch gekennzeichnet ist, daß mit der hängenden Hauptleitung (14) zwei angesetzte Leitungsenden (23, 24) verbunden und zu dieser senkrecht sind und daß in derselben mechanischen Ebene (P) und auf derselben Seite in bezug auf diese von der hängenden Hauptleitung (14) und von den zwei angesetzten Leitungen (23, 24) gebildete Ebene jede der zwei Dioden (15, 16) an einem freien Ende eines angesetzten Leitungsendes (23, 24) an einem Punkt (25, 26) angebracht ist, wobei sich der Punkt (25, 26) in einem bestand von λg/2 oder einem Vielfachen von λg/2 vom in derselben mechanischen Ebene (P) liegenden mittigen Punkt (22) der hängenden Hauptleitung (14) befindet, wobei die Wirkung der zwei Dioden auf den mittigen Punkt (22) der hängenden Leitung (14) zurückgeführt wird.

2. Ultrahochfrequenzeinrichtung gemäß Anspruch 1, dadurch gekennzeichnet, daß die zwei Dioden (15, 16) so angebracht sind, daß eine (16) mit der Anode mit einer angesetzten Leitung (24) und mit ihrer Kathode mit Masse (17) verbunden ist, während die andere (15) mit ihrer Kathode mit der anderen angesetzten Leitung (23) und mit ihrer Anode mit Masse (17) verbunden ist.

3. Ultrahochfrequenzeinrichtung gemäß Anspruch 1, dadurch gekennzeichnet, daß sie zur Verstärkung ihrer Wirkung wenigstens eine zweite Stufe (27, 28, 29, 30) aufweist, die mit der ersten (15, 16, 23, 24) identisch ist und aus zwei angesetzten Leitungsenden (27, 28), die mit der hängenden Hauptleitung (14) verbunden und zu dieser senkrecht sind, und aus zwei Dioden (29, 30), die mit den zwei angesetzten Leitungen (27, 28) an zwei Punkten, die sich von einem mittigen Punkt (31) der Hauptleitung (14) in einem bestand von λg/2 oder einem vielfachen von λg/2 befinden, verbunden sind, aufgebaut ist, wobei der entlang der Hauptleitung gemessene bestand (14) zwischen der ersten Stufe (23, 24) und der zweiten Stufe (27, 28) ein vielfaches von λg/4 ist.

4. Ultrahochfrequenzeinrichtung gemäß Anspruch 1, dadurch gekennzeichnet, daß für eine verstärkung ihrer Leistung die zwei angesetzten Leitungsenden (23, 24) jeweils die Form eines T besitzen, wobei mit den vier Enden der angesetzten Leitungen (23, 24), deren Schenkel (35, 36) (37, 38) eine Länge besitzen, die wenigstens gleich λg/4 oder einem vielfachen hiervon sind, vier Dioden verbunden sind, derart, daß die Dioden vom mittigen Punkt (22) der Hauptleitung (14) in einem bestand angeschlossen sind, der gleich λg/2 oder einem vielfachen hiervon ist.

5. Ultrahochfrequenzeinrichtung gemäß Anspruch 4, dadurch gekennzeichnet, daß für jede angesetzte Leitung die Dioden (15, 32) an den Enden der Schenkel (35, 36) des T im gleichen Sinn parallel angeschlossen sind.

6. Ultrahochfrequenzeinrichtung gemäß einem der Ansprüche 1 bis 5, dadurch gekennzeichnet, daß diese Einrichtung bei mit Masse verbundenen Dioden ein Ultrahochfrequenz-Begrenzer ist.

7. Ultrahochfrequenzeinrichtung gemäß einem der Ansprüche 1 bis 5, dadurch gekennzeichnet, daß diese Einrichtung bei mit Masse verbundenen Dioden und bei variablen Längen der angesetzten Leitungen (23, 24, 27, 28) und beständen zwischen den Stufen der Einrichtung ein Ultrahochfrequenz-Phasenschieber ist.

8. Ultrahochfrequenzeinrichtung gemäß einem der Ansprüche 1 bis 5, dadurch gekennzeichnet, daß diese Einrichtung bei mit einer Spannung polarisierten Dioden ein Ultrahochfrequenz-Umformer ist.

9. Ultrahochfrequenzeinrichtung gemäß einem der Ansprüche 1 bis 8, dadurch gekennzeichnet, daß jede Diode (15, 16, 29, 30) mittels einer die Masseebene (17) durchsetzenden Schraube an der angesetzten Leitung (23, 24) gehalten wird, wenn sich die Dioden auf derselben Seite in bezug auf die von der Hauptleitung (14) und den angesetzten Leitungen (23, 24, 27, 28) gebildete Ebene befinden.

**Claims**

1. A microwave diode device comprising a triple plate line constituted by a suspended line (14) arranged between two ground planes (17 and 18) and at least two diodes (15 and 16) placed in series and exercising their action at a single central point (22) of the suspended line (14) which carries a microwave signal with a guided wavelength of $\lambda g$, said device being characterized in that two limbs of adjacent lines (23 and 24) are connected with the principal suspended line (14) and are at right angles to it, and in that the two diodes (15 and 16) are arranged in the same mechanical plane (P) and on the same side in relation to this plane constituted by the principal suspended line (14) and by the two adjacent lines (23 and 24), each of the two diodes at one free end of a limb of an adjacent line (23 and 24), at a point (25 and 26) at a distance equal to $\lambda g/2$ or a multiple of $\lambda g/2$ thereof from the central point (22) of the principal suspended line (14), arranged in the same mechanical plane (P) the effect of the two diodes being caused at the said central point (22) of the suspended line (14).

2. The microwave device as claimed in claim 1, characterized in that the two diodes (15 and 16) are mounted so that one of them (16) has the anode connected with an adjacent line (24) and with the cathode connected with ground (17) and the other (15) has the cathode connected with the other adjacent line (23) and the anode with ground (17).

3. The microwave device as claimed in claim 1, characterized in that in order to increase its effectiveness it comprises at least one second stage (27, 28, 29 and 30) identical to the first one (15, 16, 23 and 24) and comprising two limbs of adjacent lines (27 and 28) connected with the principal suspended line (14), it itself being at a right angle, and two diodes (29 and 30) connected with the adjacent lines (27 and 28) at two points spaced by a distance equal to $\lambda g/2$ or a multiple of $\lambda g/2$ from the central point (32) of the principal suspended principal line (14), the distance measured along the principal line (14), between the first stage (23 and 24) and the second stage (27 and 28) being a multiple of $\lambda g/4$.

4. The microwave device as claimed in claim 1, characterized in that in order to increase its power the two limbs of adjacent lines (23 and 24) are each in the form of a latter T, four diodes being connected with the four ends of the adjacent lines (23 and 24) whose arms (35 and 36)(37 and 38) have a length at least equal to $\lambda g/4$ or a multiple of $\lambda g/4$ in such a manner that the diodes are connected at a distance from the central point (22) of the principal line (14) equal to $\lambda g/2$ or a multiple of $\lambda g/2$.

5. The microwave device as claimed in claim 4, characterized in that for each adjacent line the diodes (15 and 32) are connected in parallel, in the same direction, with the ends of the arms (35 and 36) of the T.

6. The microwave device as claimed in any one of the preceding claims 1 through 5, characterized in that, the diodes being connected with ground, the device is a microwave limiter.

7. The microwave device as claimed in any one of the preceding claims 1 through 5, characterized in that, the diodes being connected with ground and the lengths of the adjacent lines (23, 24, 27 and 28) and the distances between the stages of the device being adjustable, the device is microwave phase setting device.

8. The microwave device as claimed in any one of the preceding claims 1 through 5, characterized in that, the diodes being polarized by a voltage, the device is a microwave switch.

9. The microwave device as claimed in any one of the preceding claims 1 through 8, characterized in that the diodes being arranged on the same side in relation to the plane constituted by the principal line (14) and the adjacent lines (23, 24, 27 and 28), each diode (15, 16, 29 and 30) is held on an adjacent line (23 and 24) by means of a screw which extends through the ground plane (17).

FIG_1

7    11    4    9    10

3    11

12    8    13    6    5

2    1

FIG_3

FIG_2

17

19    15

14

16

20    18

FIG_4

17

19    15

14    16

20    18

FIG_5

P

17    15

25

23

22    P

14    17    16

24    26

FIG_6

FIG_7

FIG_8

FIG_9